# EUROPEAN PATENT APPLICATION

(11) **EP 0 881 677 A1**
(43) Date of publication of application: **02.12.1998**
(21) Application number: 97902695.2
(22) Date of filing: 14.02.1997
(51) Int. Cl.: H01L 23/50

(54) **SEMICONDUCTOR DEVICE AND MULTILAYERED LEAD FRAME USED FOR THE SAME**

(30) Priority: 15.02.1996 JP 27638/96
(71) Applicant: NITTO DENKO CORPORATION, Osaka 567 (JP)
(72) Inventor: HOTTA, Yuji NITTO DENKO CORPORATION, Osaka 567 (JP); KONDO, Seiji Nitto Denko Corporation, Osaka 567 (JP); OIZUMI, Shinichi Nitto Denko Corporation, Osaka 567 (JP); SAKAMOTO, Michie Nitto Denko Corporation, Osaka 567 (JP); MOCHIZUKI, Amane Nitto Denko Corporation, Osaka 567 (JP)
(74) Representative: Grünecker, Kinkeldey, Stockmair & Schwanhäusser Anwaltssozietät
(86) International application number: JP9700405
(87) International publication number: WO9730478

(57) **Abstract**

The present invention has a structure of a semiconductor device in which the side of the metallic foil 12 for mounting a semiconductor element 2 opposite to the side where the semiconductor element is mounted is exposed to the one main surface A of the device. Such a structure permits low-profiling of the semiconductor device and solves the problem in resin injection in a packaging step of the semiconductor element thereby realizing mass-production of the semiconductor device. A multi-layer lead frame for use in the semiconductor device has a structure in which the metallic foil 12 for mounting the semiconductor device 2 and inner lead portion 11a are bonded to each other through the bonding material 3 having the base material 31 and the adhesive layers 32 and 33 on both sides thereof so that the respective upper surfaces C and D of the inner lead portion 11a and semiconductor element 2 are made flush with each other and hence a level difference is removed between the wire-bonding surfaces, thereby easing the low-profiling of the semiconductor device and realizing "dambarless". The present invention is efficient for particularly a low-profiled semiconductor device having a thickness of 1 mm or less.

## Description

### TECHNICAL FIELD

The present invention relates to a resin-sealing type semiconductor device equipped with a multi-layer lead frame, and a multi-layer lead frame for use therein.

### BACKGROUND OF THE INVENTION

In a "resin-sealing type" semiconductor device, a semiconductor element such as an LSI is sealed with resin by the transfer molding technique. Such resin-sealing type semiconductor device is excellent in mass production as compared with a semiconductor device equipped with a ceramic package and can be manufactured at low cost. Therefore, the resin- sealing type semiconductor device has been widely used as, particularly, consumer products.

In recent years, in order to prevent warp of the device, such a resin-sealing type semiconductor device adopts a structure in which a semiconductor element is located at a central position of the device.

On the other hand, there is a demand of high heat dissipation due to an increase of power of the semiconductor element. In order to satisfy this demand, the resin-sealing type semiconductor device has become to use a "multi-layer" lead frame in which a metallic foil is laminated on a lead frame and the semiconductor device is mounted on the metallic foil to dissipate heat.

Meanwhile, in recent years, with a development of downsizing and low-profiling of an electronic component, there is an increasing demand of downsizing the semiconductor device. In order to satisfy this demand, the semiconductor device has been low-profiled from 3 mm to 1.4 mm and further to 1. 0 mm. However, such a tendency of low-profiling the semiconductor device leads to reduction of mass-productivity and reliability relative to packaging.

More specifically, if the semiconductor element is located at the center of the device in order to prevent warp as described above, in the case of the device having a thickness of 1 mm, a small thickness of sealing resin of 0. 2 - 0. 3 mm can be assured in the spaces above and below the semiconductor element. In a packaging process, in order to avoid a change of position in the semiconductor element, resin must be injected uniformly into the above thin upper and lower spaces, respectively. This is the major cause of reduction of the production yield in the packaging to impede the mass production of the semiconductor device having a thickness of 1 mm or less. This problem is more serious in the semiconductor device provided with the multi-layer lead frame which has upper and lower thinner spaces for injection of resin because the thickness of the metallic foil must be taken into consideration for mounting the semiconductor element.

The present invention has been accomplished under such a circumstance, and intends to provide a semiconductor device using a multi-layer lead frame and having a structure which can easily be mass-produced with high productivity, and provide a multi-layer lead frame which can be easily mass-produced for use in such a semiconductor device.

### DISCLOSURE OF THE INVENTION

The present invention relates to a semiconductor device and a lead frame for use therein, described below.
(1) A resin-sealing type semiconductor device equipped with a lead frame in which a metallic foil for mounting a semiconductor element is laminated on the one side of an inner lead portion, characterized in that the surface of said metallic foil on the side opposite to the side where the semiconductor element is mounted is exposed to the one main surface of the semiconductor device.
(2) The resin-sealing type semiconductor device according to (1), characterized in that the surface of said inner lead portion on the side opposite to the side where said inner lead portion is laminated on the metallic foil is substantially flush with the semiconductor element.
(3) The resin-sealing type semiconductor device according to (1) or (2), characterized in that said inner lead portion and said metallic foil are laminated to each other through a bonding material having a base material and adhesive layers on both sides thereof.
(4) The resin-sealing type semiconductor device according to (1), (2) or (3), characterized in that the sealing resin forming another main surface on the side opposite to the main surface to which said metallic foil is exposed is covered with another metallic foil.
(5) The multi-layer lead frame for used in a semiconductor device according to (1), (2), (3) or (4), characterized in that said metallic foil for mounting the semiconductor element and said inner lead portion are connected to each other through a bonding material having a base material and adhesive layers on both sides thereof.
(6) The multi-layer lead frame for use in the semiconductor device according to (1), (2), (3) or (4), characterized in that an adhesive layer is provided on the surface of the metallic foil on the side where the semiconductor element is located, between said metallic foil and inner lead portion, a bonding material having a base material and another adhesive layer on the one side thereof is inserted with the adhesive layer oriented to the side of said inner lead portion so that the inner lead portion and metallic foil are connected to each other by these adhesive layers through said base material intervening therebetween.
(7) The multi-layer lead frame according to (5) or (6), characterized in that the thickness of the adhesive layer located between said inner lead portion and said base material is 80 - 150 µm.
(8) The multi-layer lead frame according to (5), (6) or (7), characterized in that the main component of an organic material of each said bonding material is a thermosetting adhesive containing polycarbodiimide or fluoro-rubber as a main component.
(9) The multi-layer lead frame according to (5), (6), (7) or (8), characterized in that said base material is a metallic foil.

### BRIEF DESCRIPTION OF THE DRAWINGS

Fig. 1 is a schematic longitudinal sectional view showing a structure of the semiconductor device according to a first embodiment of the present invention;
Fig. 2 is an exploded perspective view of the semiconductor device in Fig. 1; and
Fig. 3 is a schematic longitudinal sectional view showing a structure of the semiconductor device according to a second embodiment of the present invention.

### BEST MODES FOR CARRYING OUT THE INVENTION

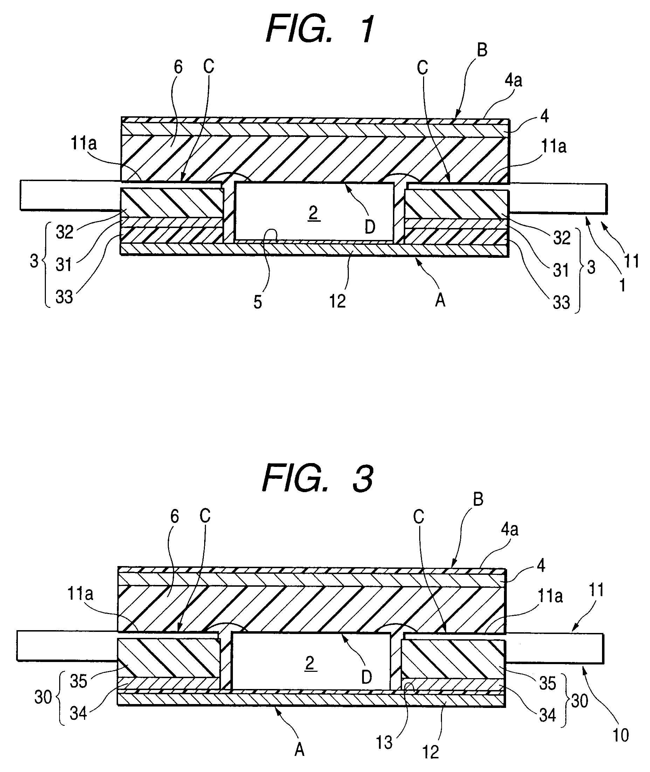

The semiconductor device according to the present invention, as typically shown in Fig. 1 or Fig. 3, in a resin-sealing type semiconductor device provided with a multi-layer lead frame 1 in which a metallic foil 12 for mounting a semiconductor element 2 is laminated on the one side of the inner lead portion 11a, is characterized in that the side of the metallic foil 12 opposite to the side where the semiconductor element is mounted is exposed to the one main surface of the device.

In the semiconductor device according to the present invention, the face C of the inner lead portion 11a on the opposite side to the side where the metallic foil 12 is laminated is preferably flush with the face D of the semiconductor element 2.

In the semiconductor device according to the present invention, the inner lead portion 11a and metallic foil 12 can be laminated to each other through a bonding material 3 comprising a base material 31 and adhesive layers 32 and 33 on both sides thereof (Fig. 1).

In the semiconductor device according to the present invention, the surface of sealing resin, constituting the main surface B on the opposite side to the main surface A where the metallic foil 12 is exposed, can be covered with another metallic foil 4.

On the other hand, the multi-layer lead frame according to the present invention is suited for use in the aforementioned semiconductor device according to the present invention. The multi-layer lead frame according to the present invention is characterized, as shown in Fig. 1, in that the metallic foil 12 for mounting the semiconductor element 2 and inner lead portion 11a are bonded to each other through the bonding material 3 comprising the base material 31 and the adhesive layers 32 and 33 on both sides thereof.

In place of such a configuration, the multi-layer lead frame according to the present invention, as shown in Fig. 3, may have a structure in which the entire surface of the metallic foil 12 on the side where the semiconductor element 2 is mounted is covered with an adhesive layer 13, and between the metallic foil 12 and inner lead portion 11a, a bonding material 30 having an adhesive layer 35 on the one side of a base material 34 is inserted with the adhesive layer 35 oriented to the side of the inner lead portion 11a so that the inner lead portion 11a and metallic foil 12 are bonded to each other by these adhesive layers 13 and 35 with the base material 23 intervening therebetween.

In the multi-layer lead frame according to the present invention, the adhesive layer 32 or 35 between the inner lead portion 11a and base material 31 may be preferably 80 - 150 µm thick.

In the multi-layer lead frame according to the present invention, the adhesive layers 32 and 33 on both sides of the bonding material 3 and the adhesive layer 35 on the one side of the bonding material 30 has preferably a main organic component of thermosetting adhesive having a main component of polycarbodiimide or fluoro-rubber.

In the multi-layer lead frame according to the present invention, the base materials 31 and 34 of the bonding materials 3 and 30 are preferably metallic foils, respectively.

A detailed explanation will be given of the semiconductor device and multi-layer lead frame according to the present invention.

The material of a lead frame body 11 of the semiconductor device and multi-layer lead frame according to the present invention may be several known kinds of metals usually used in the pertinent field of technique, e. g. Cu alloy and 42 alloy, but is preferably Cu from the viewpoint of thermal conductivity.

The material of the metallic foil 12 for mounting the semiconductor element 1, used in the semiconductor device and multi-layer lead frame according to the present invention, may be, likewise, several known kinds of metals, but is preferably Cu alloy, 42 alloy, 45 alloy or aluminum. The thickness of the metallic foil 12 may be 1 - 100 µm or more preferably 10 - 50 µm.

In the semiconductor device and multi-layer lead frame according to the present invention, the base material 31 or 34 of the bonding material 3 or 30 defined in claims 3 and 5 or claim 6 may be several kinds of refractory metal, but is preferably a resin film such as polyimide and polyetherimide, or metallic material such as an aluminum foil and Cu foil. Particularly, the metallic material is useful to prevent reduction of the strength due to low-profiling of the semiconductor device.

The base material 31 or 34 may have an optional thickness as long as it is not thicker than that of the semiconductor element 2, but is preferably 15 - 250 µm thick. By suitably setting the thickness of the base material 31 or 34 in relation to the thickness of the semiconductor element 2 and that of the inner lead portion 11a, the upper surface C of the inner lead portion 11a (which is opposite to the face abutting on the metallic foil 12) may be substantially flush with the upper surface of the semiconductor element 2, as defined in claim 2.

The adhesive used for the adhesive layers 32 and 33 or 35 in the bonding material 3 or 30 may be several kinds of refractory adhesives such as epoxy resin and polyetherimide resin, or polyamideimide resin, polyimide resin and carbodimide resin. The adhesive layers 32, 33 and 35 may contain several kinds of fillers (e.g. silica) for suppressing the water absorbance ratio.

The thickness of the adhesive layers 32, 33 and 35 may be optional in a range of 5 - 300 µm. However, the thickness of the adhesive layer 32 or 35 intervening between the inner lead portion 11a and the base material 31 or 34 is particularly set at 80 - 150 µm so that the lead frame can be made "dambarless".

In order to implement the "dambarless", the main component of the organic material of the adhesive layer 32 or 35 is preferably polycarbodimide or fluoro-rubber.

The polycarbodiimide can be expressed by the following general Equation (1). The expression - R - in Equation (1) may be any of structural equations (A) to (D), but is particularly preferably the material expressed by (D).

- (R - N = C = N)n - (1)

where - R - is

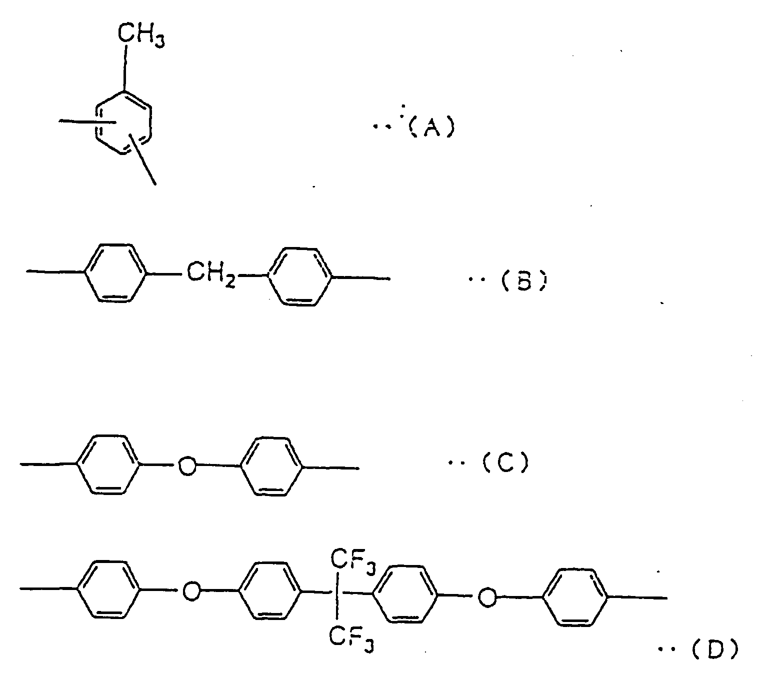

On the other hand, the fluoro rubber used in the present invention may be any suitable elastomer containing fluorine e.g. an fluorine containing thermoplastic elastomer such as a hexafluoropropylene-vinylidenefluoride copolymer, polytetrafluoroethylene-propylene copolymer and perfluoromethylvinyleether-propylene copolymer; fluorine-containing silicon rubber; and fluorine-containing polyester rubber. Such fluorine-containing elastomer is caused to contain any hardening starting agent, e.g. substance capable of generating radicals through thermal decomposition such as several kinds of peroxides so that it is imparted thermal setting property.

Further, in the semiconductor device and multi-layer lead frame according to the present invention, the adhesive layer 13 provided on the side of the metallic foil 12 where the semiconductor element is mounted, as defined in claim 6, may be also several kinds of refractory adhesive, like the adhesive layers 32, 33 and 35, such as epoxy resin and polyetherimide resin, or polyamideimide resin, polyimide resin and carbodimide resin. In order to increase the thermal conductivity, the adhesive layer 13 can contain a filler of several kinds of high thermal conductivity material such as Ag.

In the semiconductor device according to the present invention, the substance of the metallic foil 4 covering the main surface B on the opposite side to the one main surface A to which the metallic foil 12 for mounting the semiconductor element is exposed is not particularly limited, but is preferably Cu alloy, 42 alloy or aluminum alloy. The thickness of the metallic foil 4 may be optional in a range of 1 - 100 µm, but preferably 10 - 50 µm. The method of covering the main surface B with the metallic foil 4, i.e., fixing the metallic foil to the surface of sealing resin may be optional. This can be implemented by a method in which with an adhesive layer provided on the one side of the metallic foil 4 being provisionally secured within a cavity mold, a semiconductor element and a lead frame are inserted in the cavity mold and clamped and sealing resin is injected (Japanese Patent Publication No. Nei. 7-288263), or another method in which a parting film having a parting property for the sealing resin intervenes between the adhesive layer for provisional securing and the molding (Japanese Patent Publication No. Hei. 6-147458).

The material of the sealing resin in the semiconductor device according to the present invention may be several known materials in the pertinent technical field. The resin component may be heat resisting resin such as epoxy resin and polyimide resin, and the filler material may be silica, alumina, etc.

The sealing resin used in the present invention is desired to have an average linear expansion coefficient of 1.2 - 2.4 x 10⁻⁵ (1/°C) from the viewpoint of preventing warp in the semiconductor device. From the same viewpoint, the thickness of the semiconductor element used is preferably 200 - 350 µm.

The semiconductor device structure in which the metallic foil 12 for mounting the semiconductor element 2 is exposed to the one main surface A of the semiconductor device can low-profiled compared with the an ordinary semiconductor device structure in which the semiconductor element is centrally located in the semiconductor device by the degree that sealing resin is not provided on the side of the metallic foil 12 opposite to the side where the semiconductor element is located. In this case, a step of packaging the semiconductor device according to the present invention having the structure described above is a single-side molding in which the device is "transfer-molded" so that the side of the metallic foil 12 is exposed. For this reason, no problem of location displacement of the element and warping of the device which are attributable to non-uniformity in a resin injection speed above and below the semiconductor element at the time of injecting the sealing resin. Thus, the cause of impeding mass-production in the packaging step of a conventional semiconductor device is excluded so that the ultra low-profiled semiconductor element can be manufactured with a high yield.

Further, between the metallic foil 12 for mounting the semiconductor element and the inner lead portion 11a, the boding material 3 having the adhesive layers on both sides of the base material 31 or the bonding material 30 having the adhesive layer 35 on the single side of the base material 34 intervenes. Thus, the upper surface C of the inner lead portion 11a is shifted upward so that it can be made substantially flush with the upper face D of the semiconductor element 2. In this way, the faces of the semiconductor element 2 and inner lead portion 11a within the sealing resin which are to be subjected to wire-bonding are made coplanar with each other. This further facilitates the low-profiling of the semiconductor device.

The base material 31 or 34 intervening between the metallic foil 12 and the inner lead portion 11a serves as a material for improving the strength of the semiconductor device. Particularly, the material 31 or 34 is made of a metallic foil and the main surface B on the opposite side to the exposed surface of the metallic foil 12 for mounting the semiconductor element 2 is also covered with the metallic foil 4. Such a configuration prevents reduction of the strength of the semiconductor device due to low-profiling, and permits an ultra low-profiled and reliable semiconductor device to be mass-produced with high yield. Incidentally, the metallic foil 4 covering the main surface B serves to suppress moisture absorption by the sealing resin and improve heat dissipation.

The multi-layer lead frame according to the present invention has a structure in which the inner lead portion 11a and metallic film 12 for mounting the element are connected to each other by the bonding material 3 having the base material 31 and the adhesive layers 32 and 33 on both sides thereof. Otherwise, the multi-layer lead frame according to the present invention has another structure in which the adhesive layer 13 is provided on the surface of the metallic foil 12 on the side on which the semiconductor element is mounted, and between it and the inner lead portion 11a, the bonding material 30 having the base material 34 and the adhesive layer 35 on the one side thereof intervenes in a state of the adhesive layer 35 being oriented toward the inner lead portion 11a. Such a structure of the multi-layer lead frame according to the present invention permits the structure of the semiconductor device according to the present invention to be easily realized and facilitates its mass productivity.

In these structures of the multi-layer lead frame, the thickness of the adhesive layer 32 or 35 between the inner lead portion 11a and the base material 31 or 34 is set at 80 - 150 µm. In this case, the adhesive layer 32 or 35 constitutes a resin dam in relation to the thickness of 125 - 350µm of a lead frame body 11 which is usually used as QFP. This realizes "dambarless" of the lead frame, and hence permits the step of cutting the dam bar to be omitted after the sealing resin is molded. Further, where the main component of the organic material of the adhesive layer 32 or 35 is made of polycarbodiimide or fluoro rubber, the "dambarless" can be further easily realized.

Specifically, the thermosetting adhesive having polycarbodiimide or fluoro-rubber as the main component of an organic material can be adhered provisionally in a hot-melt manner through slight heating, and hence completely adhered by hardening through sufficient heating.

Therefore, with the adhesive layer 32 or 35 having such an adhesive as a main component intervening between the inner lead portion 11a and the base material 31 or 33, in manufacturing the multi-layer lead frame according to the present invention, the inner lead portion 11a is embedded in the adhesive layer 32 or 35 by heating and pressurizing. Thereafter, the inner lead portion 11a is heated suitably. Thus, the resin dam can be surely formed between respective leads.

Among the multi-lead frames according to the present invention, in the structure in which the inner lead portion 11a is connected, through the single adhesive material 30, to the adhesive layer 13 provided on the surface of the metallic foil 12 where the element is located, the semiconductor element 2 can be directly fixed to the metallic foil 12 using the adhesive layer 13. Therefore, the die bonding step does not require supply of an additional die bonding material. This greatly contributes to simplifying the die bonding step.

### 1st Embodiment

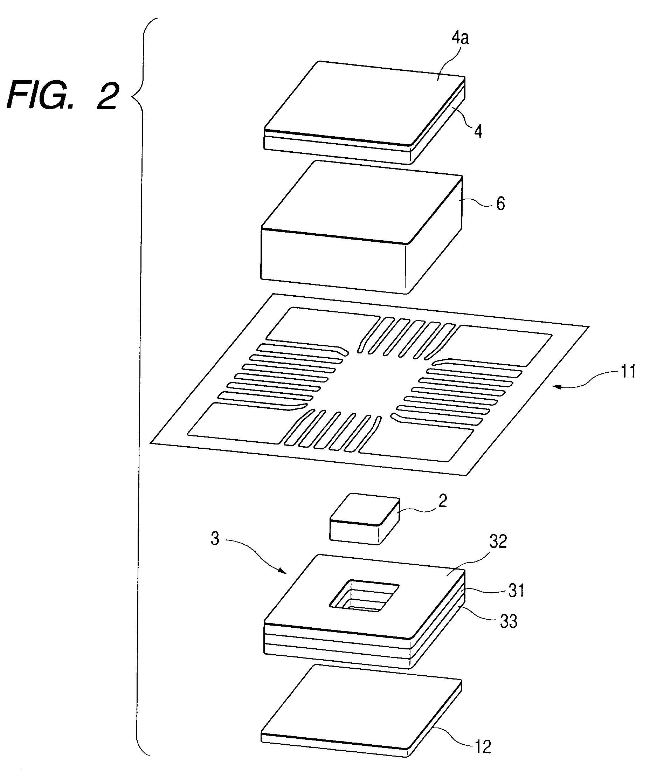

Fig. 1 is a schematic sectional view showing the construction of a semiconductor device according to the first embodiment. Fig. 2 is an exploded perspective view of the semiconductor device.

First, on both surfaces of a Cu foil having a thickness of 35 µm (BDH available from MITSUI METAL CO.LTD), polycarbodimide layers each having a thickness of 100 µm expressed by a structural equation (D) of - R -. Thus, the double-face bonding material 3 having the adhesive layers 32 and 33 of polycarbodiimide on both surfaces of the base material 31 of the Cu foil. Thereafter, the bonding material 3 is machined in a shape as shown in Fig. 2.

The double-face bonding material 3 thus obtained is sandwiched between the Cu foil 12 (FX-BSH) 12 having a thickness of 35 µm cut in 28 mm square and lead frame 11 for QFP in 28 mm square (with no die pad and 125 µm thickness). In this state, they are stacked, and heated and pressurized under a condition of 200°C and 100 kg/cm². Thus, the multi-layer lead frame 1 is manufactured in which the metallic foil 12 of Cu and the inner lead portion 11a are connected to each other by the double-face bonding material 3 including the base material 31 of Cu.

In this multi-layer lead frame thus formed, the space among the leads of the inner lead portion 11a is filled with the adhesive layer 32 so that the dam of resin has been formed.

On the other hand, on the single face of the Cu foil having a thickness of 35 µm (FX-BSH available from MITSUI METAL CO.LTD), a provisional adhesive layer of epoxy resin, rubber, silica, carbon black or wax is formed to fabricate the metallic foil 4 with the provisional adhesive layer 4a having a thickness of 10 µm formed on the single surface.

The metallic foil 4 is provisionally adhered to the one cavity face of a cavity mold for single-face molding by means of the provisional adhesive layer 4a. The semiconductor element 2 having a thickness of 280 µm is bonded to the upper surface of the metallic foil 12 of the multi-layer lead frame 1 using silver paste 5 and is subjected to wire-bonding. The semiconductor element thus obtained is inserted into the cavity mold. Epoxy sealing resin 6 (filler amount: 88 % and linear expansion coefficient: 0.9 x 10⁻⁵/°C) is injected into the cavity mold. Thus, the semiconductor device having a thickness of 0.7 mm having a structure as shown in Fig. 1 is manufactured in which the metallic foil 12 is exposed to the one main surface A while the other main surface is covered with the metallic foil 4, and the upper surface C of the inner lead portion 1a is substantially flush with the upper surface D of the semiconductor element 2.

In such a packaging step, the lead frame 11 having no dam bar was used. Nevertheless, leak of the sealing resin did not occur because the adhesive layer 32 forms the resin dam. No warp was not produced in the semiconductor device. Incidentally, the provisional adhesive layer 4a formed on the one surface of the metallic foil 4, which is left after the molding step, can be efficiently employed as a marking layer of the semiconductor device.

The completed semiconductor device, the main surfaces A and B on both sides of which are covered with the metallic foils 12 and 4, provides excellent moisture-resistance and heat dissipation. Further, because of the base material 31 of metallic foil inserted into the sealing resin 6 as well as the metallic foils 12 and 4 provided on the main surfaces A and B, the semiconductor device according to the present invention is high in strength although it is low-profiled.

### 2nd Embodiment

Fig. 3 is a schematic longitudinal sectional view showing the structure of a semiconductor device according to a second embodiment of the present invention.

The second embodiment is mainly different from the first embodiment in that an adhesive layer 13 having a thickness of 10 µm and made of a polycarbodiimide layer containing Ag by 90 weight % is formed on the single surface of the metallic foil 12 for mounting the element as in the first embodiment, and in place of the double-face bonding material 13 used in the first embodiment, a single-face bonding material 30 with the adhesive layer 35 on the single face of a base material 34. Additionally, the base material 34 of the single face bonding material 30 and the material of the adhesive layer 35 are entirely the same as the base material 31 and those of the adhesive layers 32 and 33. The thickness of the base material 34 is set at 50 µm and the thickness of the adhesive layer 35 is set at 150 µm.

The same lead frame body 11, metallic foil 4 for covering the main surface B and sealing resin 6 as those in the first embodiment were used in this embodiment.

In the multi-layer lead frame 10 in this embodiment, with the adhesive layer 35 of the single-face bonding material 30 oriented to the side of lead frame body 11, the single-face bonding material 30 intervenes between the lead frame body 11 and the metallic foil 12. In this state, the single face bonding material 30 is heated slightly. Thus, the inner lead portion 11a is provisionally bonded to the metallic layer 12 through the adhesive layer 35 and the base material 34 is bonded to the metallic foil 12 through the adhesive layer 13. In this state, the die bonding step is performed.

In the die bonding step, the semiconductor element 2 is directly crimped on the adhesive layer 13 on the metallic foil 12 within an environment at 175 °C without using any additional die bonding material.

After the wire bonding step, in the same packaging step as in the first embodiment, the sealing resin is injected. Thus, a semiconductor device having a thickness of 0. 7 mm as shown in Fig. 2 is completed in which the metallic foil 12 is exposed to the one main surface A whereas the other main surface B is covered with the metallic foil 4 and the upper surface D of the semiconductor element 2 is flush with the upper surface C of the inner lead portion 11a.

In the second embodiment also, the "dambarless" can be implemented. Therefore, the semiconductor device can be obtained which is low-profiled and high in strength and provides excellent moisture-resistance and heat dissipation.

### INDUSTRIAL APPLICABILITY

In the semiconductor device according to the present invention, the metallic foil for mounting the semiconductor element is exposed to the one main surface of the semiconductor device so that the thickness of the sealing resin can be reduced, thereby low-profiling the semiconductor device. In addition, in such a structure, the packaging step is the one-side molding so that the warp does not occur which is due to non-uniformity of the injection speed of sealing resin in spaces above and below the semiconductor and element and is problematic in the packaging step of the conventional semiconductor device in which the element is centrally located. Thus, the low-profiled semiconductor device can be manufactured at high productivity and with a high yield.

In the multi-layer lead frame according to the present invention, with the bonding material with the adhesive layer on both sides or one side of the base material intervening between the inner lead portion and the metallic foil for mounting the element, they are connected to each other. Therefore, by suitably selecting the thickness and material of the adhesive layer between the inner lead portion and base material, the resin dam can be formed using the adhesive layer, thus realizing the "dambarless". The base material serves to improve the strength of the semiconductor device according to the present invention, and also to locate the inner lead portion at a position elevated by its thickness so that the wire-bonding surface of the inner lead portion is flush with that of the semiconductor element, thereby permitting the highly strong and ultra low-profiled semiconductor device to be mass-produced.

## Claims

1. A resin-sealing type semiconductor device equipped with a lead frame in which a metallic foil for mounting a semiconductor element is laminated on one side of an inner lead portion thereof, wherein a first surface of said metallic foil on a side opposite to a side where the semiconductor element is mounted is exposed to one main surface of the semiconductor device.

2. The resin-sealing type semiconductor device according to claim 1, wherein a surface of said inner lead portion on a side opposite to a side where said inner lead portion is laminated on the metallic foil is substantially flush with the semiconductor element.

3. The resin-sealing type semiconductor device according to any one of claims 1 and 2, wherein said inner lead portion and said metallic foil are laminated to each other through a bonding material having a base material and adhesive layers on both sides thereof.

4. The resin-sealing type semiconductor device according to any one of claims 1 to 3, wherein the sealing resin forming another main surface on a side opposite to the main surface to which said metallic foil is exposed is covered with another metallic foil.

5. A multi-layer lead frame used for a semiconductor device according to any one of claims 1 to 4, wherein said metallic film for mounting the semiconductor element and said inner lead portion are connected to each other through a bonding material having a base material and adhesive layers on both sides thereof.

6. The multi-layer lead frame for use in the semiconductor device according to any one of claims 1 to 4, wherein an adhesive layer is provided on the surface of the metallic foil on the side where the semiconductor element is located, and between said metallic foil and inner lead portion, a bonding material having a base material and another adhesive layer on the one side thereof is inserted, with the adhesive layer oriented to the side of said inner lead portion so that the inner lead portion and metallic foil are connected to each other by these adhesive layers through said base material intervening therebetween.

7. The multi-layer lead frame according to any one of claims 5 and 6, wherein a thickness of the adhesive layer located between said inner lead portion and said base material is 80 - 150 µm.

8. The multi-layer lead frame according to any one of claims 5 to 7, wherein the main component of an organic material of each said bonding material is a thermosetting adhesive containing one of polycarbodiimide and fluoro-rubber as a main component.

9. The multi-layer lead frame according to claim 5 to 8, wherein said base material is a metallic foil.

## Amended claims

### Amended claims under Art. 19.1 PCT

1. (Amended) A resin-sealing type semiconductor device equipped with a lead frame in which a metallic foil for mounting a semiconductor element is laminated on one side of an inner lead portion, wherein a surface of said metallic foil on a side opposite to a side where the semiconductor element is mounted is exposed to one main surface of the semiconductor device, and a surface of said inner lead portion on a side opposite to a side where said inner lead portion is laminated on the metallic foil is substantially flush with the semiconductor element by a bonding material having a base material and adhesive layers on both sides thereof.

2. (Amended) The semiconductor device according to claim 1, wherein that the inner lead portion is partially embedded in the adhesive layer on one side of the bonding material.

3. (Amended) A resin-sealing type semiconductor device equipped with a lead frame in which a metallic foil for mounting a semiconductor element is laminated on one side of an inner lead portion, wherein a surface of said metallic foil on a side opposite to a side where the semiconductor element is mounted is exposed to one main surface of the semiconductor device, wherein a surface of said inner lead portion on a side opposite to a side where said inner lead portion is laminated on the metallic foil is substantially flush with the semiconductor element by an adhesive layer formed on an entire surface of said metallic foil and a bonding material having a base material and another adhesive layer on the one side thereof.

4. (Amended) The semiconductor device according to claim 3, wherein the inner lead portion is partially embedded in the adhesive layer on one side of the bonding material.

5. (Amended) The resin-sealing type semiconductor device according to any one of claims 1 to 4, wherein the sealing resin forming another main surface on a side opposite to the main surface to which said metallic foil is exposed is covered with another metallic foil.

6. (Amended) A multi-layer lead frame for used in a semiconductor device according to any one of claims 1, 2 and 5, wherein that the sealing resin, characterized in that said metallic film for mounting the semiconductor element and said inner lead portion are connected to each other through a bonding material having a base material and adhesive layers on both sides thereof.

7. (Amended) A multi-layer lead frame for use in the semiconductor device according to any one of claims 3 to 5, wherein an adhesive layer is provided on the entire surface of the metallic foil on the side where the semiconductor element is located; and between the adhesive layer on the metallic foil and inner lead portion, a bonding material having another adhesive layer on the one side of a base material is inserted, with the adhesive layer oriented to the side of said inner lead portion so that the inner lead portion and metallic foil are connected to each other by these adhesive layers through said base material intervening therebetween.

8. (Amended) The multi-layer lead frame according to any one of claims 6 and 7, wherein the thickness of the adhesive located between said inner lead portion and said base material is 80 - 150 µm.

9. (Amended) The multi-layer lead frame according to any one of claim 6 to 8, wherein that the main component of an organic material of each said bonding material is a thermosetting adhesive containing one of polycarbodiimide and fluoro-rubber as a main component.

10. (Amended) The multi-layer lead frame according to any one of claims 6 to 8, wherein said base material is a metallic foil.
